(19) Europäisches Patentamt
European Patent Office
Office européen des brevets

(11) **EP 0 892 082 A1**

(12) **EUROPÄISCHE PATENTANMELDUNG**

(43) Veröffentlichungstag:
**20.01.1999 Patentblatt 1999/03**

(51) Int. Cl.$^6$: **C23C 16/40**

(21) Anmeldenummer: **98107568.2**

(22) Anmeldetag: **23.04.1998**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **14.07.1997 DE 19730119**

(71) Anmelder:
**SIEMENS AKTIENGESELLSCHAFT**
**80333 München (DE)**

(72) Erfinder:
**Hintermaier, Frank, Dr.**
**81373 München (DE)**

(54) **Verfahren zur Herstellung von Dünnfilmen aus oxidischer Keramik**

(57) Die vorliegende Erfindung betrifft ein Verfahren zur Herstellung von Dünnfilmen aus oxidischer Keramik durch Abscheiden von Metalloxiden auf eine Oberfläche, bei dem zur Initiierung der Oxidation der metallorganischen Precursoren in Beschleuniger zugegeben wird.

Fig.1

**Beschreibung**

Zur Abscheidung von Dünnfilmen aus oxidischer Keramik werden im zunehmenden Maße CVD-Prozesse (Chemical Vapour Deposition) eingesetzt. Dabei werden als Ausgangsmaterialien metallorganische Precursoren verwendet, die auf einer heißen Substrat- bzw. Waferoberfläche in einem Temperaturbereich von 300 bis 800°C zerfallen und dabei in die entsprechenden Oxide übergehen. Für die Oxidation der metallorganischen Precursoren wird ein oxidierend wirkendes Gas, z.B. $O_2$, verwendet, welches die organische Komponente der Precursoren verbrennt. Derartige Oxidationsprozesse laufen meist unter Involvierung von Radikalen ab. Häufig kommt es zur Ausbildung von Radikalkettenreaktionen.

Bisher wurden ausschließlich Oxidationsgase, z.B. $O_2$ oder deren Gemische, z. B. $O_2/N_2O$, eingesetzt. Bei der Herstellung z.B. BST ((Ba, Sr)$TiO_3$) werden die Precursoren Sr(thd)$_2$(tetraglyme), Ba(thd)$_2$(tetraglyme)und (Ti(OiPr)$_2$(thd)$_2$ bei Temperaturen im Bereich von 450 bis 650°C mit $O_2/N_2O$ als Oxidationsmittel umgesetzt. Aufgrund der unvollständigen Verbrennung des Kohlenstoffs der metallorganischen Precursoren ist allerdings die abgeschiedene BST-Schicht erst bei 500°C so rein, daß akzeptierbare elektrische Daten gemessen werden können.

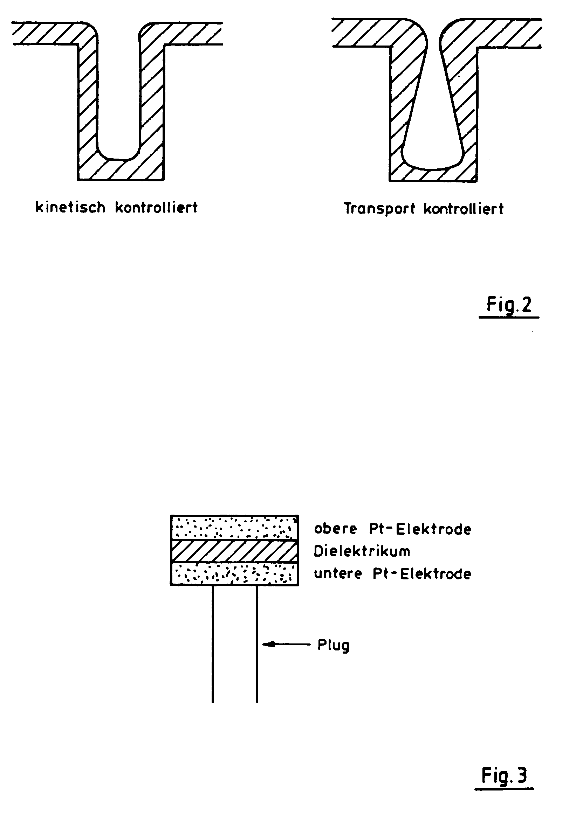

Im Fall des BST hat es sich gezeigt, daß bei einer Abscheidung bei tieferen Temperaturen, das heißt, bei Temperaturen unterhalb von 500°C, eine gute Konformität der Abscheidung erreicht wird, da die Abscheidung vor allem kinetisch kontrolliert abläuft. Demgegenüber wird oberhalb von 500°C die Abscheidung zunehmend Transport kontrolliert. Dieses fuhrt zu einer verminderten Konformität, wie aus der angefügten schematischen Darstellung in Figur 2 hervorgeht.

Bei der Herstellung von Halbleiterelementen in der Mikroelektronik werden zunehmend Dünnfilme aus oxidischer Keramik verwendet. Zur Herstellung von DRAMs (dynamic random access memory-Chips oder DRAM-Chips) und FRAMs(ferroelectric random access memory-Chips oder FRAM-Chips) können beispielsweise paraelektrisches BST und ferroelektrisches SBT (SrBi$_2$Ta$_2$O$_9$) als Dielektrikum im Speicherkondensator integriert werden. Beim Aufbau des Speicherkondensators wird nach dem Stack-Prinzip verfahren, bei dem eine Barriere zwischen unterer Elektrode (Pt-Elektrode) und Plug notwendig ist. Die Barriere soll eine Diffusion in beide Richtungen verhindern, das heißt, die Diffusion von Sauerstoff oder mobilen Komponenten des Dielektrikums (z.B. BiO$_x$ (x=0-2,5)) in Richtung Plug als auch die Diffusion von Plugmaterial durch das Platin zum Dielektrikum. Außerdem kann die Barriere als Haftvermittler für die Platinschicht dienen. Ein Stack-Kondensator kann z.B. so aufgebaut sein wie in Figur 3 dargestellt, also eine auf dem Kontaktplug sitzende unter Pt-Elektrode mit darüberliegender Dielektrikumsschicht und eine hierüber angeordnete obere Pt-Elektrode aufweisen.

Niedrigere Abscheidetemperaturen, beispielsweise beim CVD-Prozeß, als die bisher verwendeten Abscheidetemperaturen (BST: 500 bis 600°C; SBT: 500 bis 700°C) bieten folgende Vorteile:

a) durch kinetisch kontrollierte Abscheidung kommt es zu einer besseren Konformität der Keramikschicht, so daß eine höhere Integrierbarkeit gewährleistet wird; und
b) durch die geringere Belastung der Sauerstoffbarriere im Stack-Kondensator wird eine einfachere Barrierenauswahl möglich.

Es ist daher Aufgabe der vorliegenden Erfindung, ein Verfahren zur Herstellung von Dünnfilmen aus oxidischer Keramik anzugeben, bei dem die Abscheidetemperatur der Metalloxide deutlich herabgesetzt wird.

Diese Aufgabe wird durch ein Verfahren gemäß Patentanspruch 1 gelöst.

Die vorliegende Erfindung betrifft ein Verfahren zur Herstellung von Dünnfilmen aus oxidischer Keramik durch Abscheiden von Metalloxiden auf eine Oberfläche, das folgende Schritte umfaßt:

- Verdampfen von metallorganischen Precursoren zur Bildung gasförmiger Precursoren,

- Zugabe eines Beschleunigers zur Initiierung der Oxidation der Precursoren,

- Oxidation der Precursoren zur Bildung von Metalloxiden und

- Abscheiden der Metalloxide auf der Oberfläche.

Die Unteransprüche betreffen bevorzugte Ausführungsformen des erfindungsgemäßen Verfahrens.

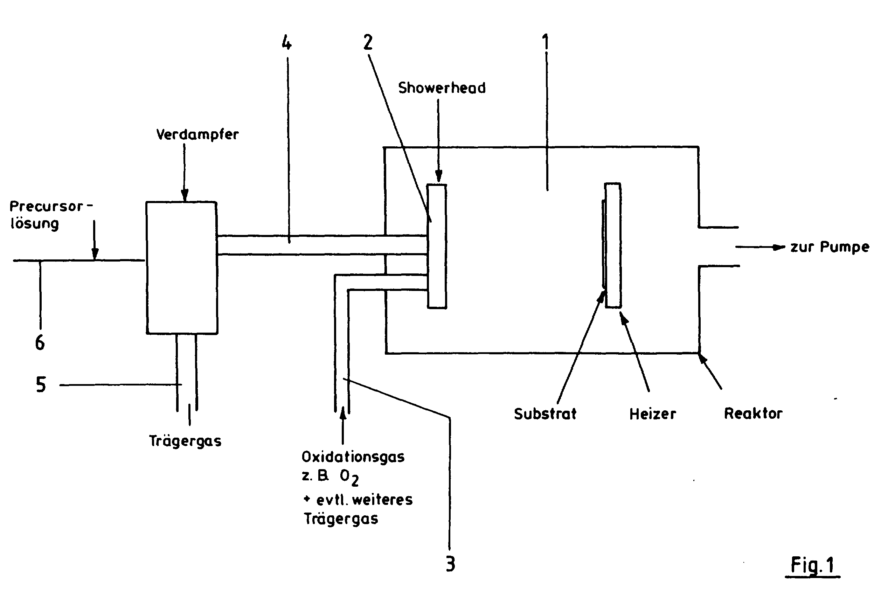

Fig. 1 zeigt den schematischen Aufbau einer CVD-Anlage.

Mit dem erfindungsgemäßen Verfahren wird der meist radikalisch ablaufende Oxidationsprozeß der metallorganischen Precursoren bereits bei tieferen Temperaturen durch die Zugabe eines Beschleunigers künstlich initiiert. Es muß demnach nicht abgewartet werden, bis der Oxidationsprozeß bei einer höheren Temperatur von selbst zustande kommt. Die Initiierung mittels Beschleunigern führt zu Radikalkettenreaktionen durch Radikale bzw. Bildung von Beschleuniger-Radikalen, wobei der metallorganische Precursor abgebaut bzw. oxidiert wird. Zur Initiierung solcher Kettenreaktionen sind daher Moleküle befähigt, die entweder bereits Radikale sind oder bereits bei geringerer Erwärmung in Radikale zerfallen.

Des weiteren kommt es bei dem erfindungsgemäßen Verfahren zu einer Erhöhung der Abscheiderate bei den niedrigeren Temperaturen und zu einer besseren Verbrennung von Restkohlenstoff.

Als Beschleuniger werden niedrigmolekulare Verbindungen bzw. Moleküle verwendet. Die Moleküle dienen lediglich zum Starten der Oxidationskette. Zur Oxidation selbst steht ein Oxidationsgas oder ein Oxidationsgasgemisch zur Verfügung. Als Oxidationsgas bzw. Oxidationsgemisch kann auch ein Plasma, z.B. ein Sauerstoffplasma, verwendet werden.

Die initiierten Radikalprozesse können sowohl in der Gasphase als auch an der Substratoberfläche ablaufen. Es gibt Hinweise darauf, daß an der Substratoberfläche ein weiterer Aktivierungsmechanismus abläuft. Die zugesetzten Beschleuniger können bei erhöhter Temperatur und unter dem Einfluß des Substrats zerfallen bzw. reagieren und somit reaktive Spezies, die auch nicht-radikalischer Natur sein können, bilden. Die Beschleuniger oder deren reaktiven Spezies können ihrerseits die metallorganischen Precursoren aktivieren und deren Oxidation beschleunigen. Repräsentative Beispiele für solche reaktive Spezies sind Carbokationen von organischen Estern oder Carbene von Diazoverbindungen.

Wie bereits oben ausgeführt, kann die Initiierung der Oxidation der metallorganischen Precursoren durch Beschleuniger-Radikale oder durch Bildung von Beschleuniger-Radikalen erfolgen. Je nach Natur des Beschleunigers liegt er entweder bereits unter Normalbedingungen (25°C, 1 atm.) radikalisch vor oder er zerfällt im Reaktor auf dem Weg zur heißen Substratoberfläche in Radikale. Er kann aber auch in der Grenzschicht zur heißen Substratoberfläche oder auf der heißen Substratoberfläche selbst in Radikale zerfallen. Folgende Beschleunigermoleküle werden bevorzugt eingesetzt:

1. Moleküle, die bereits Radikale sind. Dazu gehören beispielsweise NO, $NO_2$ und $ClO_2$. Es ist ebenfalls möglich, auch Mischungen solcher Radikale zu verwenden.

Beispielsweise entsteht mit $NO_2$ als Beschleuniger, $O_2$ als Oxidationsmittel und einem Kohlenwasserstoff RH (organischer Teil des metallorganischen Precursors) die folgende Radikalkettenreaktion:

$$RH + NO_2 \cdot \rightarrow R \cdot + HNO_2, R \cdot + O_2 \rightarrow ROO \cdot, ROO \cdot + RH \rightarrow ROOH + R \cdot, ROOH \rightarrow RO \cdot + HO \cdot$$

(diese beiden Radikale sind neu und lösen ihrerseits wieder Ketten aus)
Die Radikalkettenreaktion beginnt mit diesen Molekülen bereits nach Einlaß in den Reaktor.

2. Moleküle, die bereits bei erhöhter Temperatur in Radikale zerfallen, beispielsweise ab 100°C. Diese Moleküle zerfallen im Zuge der Aufheizung des Precursorgases im Reaktor auf dem Weg zur heißen Substratoberfläche in Radikale. Diese Moleküle liegen bereits unmittelbar nach Einlaß in den Reaktor als Radikale vor.

Als Beschleunigermoleküle kommen hierzu alle Moleküle in Frage, die als Initiatoren für die radikalische Polymerisation von Kunst- und Verbundstoffen geeignet sind. Dazu zählen Carbonylperoxide, wie Dibenzoylperoxid; Persäuren und deren Ester; Dialkylperoxide und Diarylperoxide sowie organische Azoverbindungen, wie z.B. a,a'-Azobis(isobutyronitril) und Azobenzol.

3. Moleküle, die zwischen 70 und 200°C in Radikale zerfallen. Dazu können Salpetersäureester organischer Alkohole (z.B. $CH_3ONO_2$, $CH_3CH_2ONO_2$) oder Salpetersäureester organischer Alkohole (z.B. Isoamylnitrit $((CH_3)_3CHCH_2CH_2ONO))$ genannt werden. Es kann auch $H_2O_2$ eingesetzt werden.

4. Moleküle, die bei Temperaturen oberhalb von 300°C zerfallen. Als Beispiele können Nitroalkane (z.B. $CH_3NO_2$), Nitroaromaten (z.B. $C_6H_5NO_2$), Nitrosoalkane (z.B. $CH_3NO$) und Nitrosoaromaten (z.B. $C_6H_5NO$) verwendet werden. Die Radikale werden in diesem Fall erst unmittelbar vor der heißen Substratobefläche erzeugt.

5. Radikale, die durch physikalische Aktivierung erzeugt werden. Beispielsweise können als Radikale Sauerstoffradikale verwendet werden, die durch UV-Licht-Bestrahlung von Sauerstoff ($O_2$) oder von $N_2O$, NO oder $NO_2$ erzeugt werden.

Beispielsweise können alle anderen der unter 1. bis 4. genannten Moleküle durch UV-Bestrahlung zum Zerfall in die entsprechenden Radikale angeregt werden. Eine andere Möglichkeit, den Zerfall der oben genannten Moleküle in Radikale zu bewirken, ist die Erzeugung eines Plasmas, z.B. im elektrischen Wechselfeld (z.B. Sauerstoffplasma).

Die Beschleunigermoleküle werden bevorzugt im molaren Verhältnis von Beschleuniger zu Precursor in einem Bereich von 1:1 bis 1:1000 eingesetzt. Ein molares Verhältnis von ...... ist ganz besonders bevorzugt. Bei reaktiven Spezies als Beschleuniger liegt das molare Verhältnis von Beschleuniger zu Precursor im Bereich von 1:5 bis 1:0,1.

Als metallorganische Precursoren können alle metallorganischen Verbindungen verwendet werden, die zur Herstellung von Dünnfilmen aus oxidischer Keramik durch Abscheiden ihrer Metalloxide auf eine Oberfläche geeignet sind. Beispielsweise können als metallorganische Precursoren. Beispielsweise können als metallorganische Precursoren eingesetzt werden: $BiPh_3$, $Bi(thd)_3$, Bi-pivalat, Trispentoxylatobismuth, Bitris(dimethylamid), $Ta(OEt)_5$, $Ta(thd)(OiPr)$, $Sr(thd)_2$, $Ba(thd)_2$, $Ti(thd)_2(OiPr)_2$, $Ti(OiPr)_4$, $Zr(thd)_4$, $Pb(thd)_2$ und/oder deren Mischungen eingesetzt werden.

Die Verdampfung der metallorganischen Precursoren kann in herkömmlichen Verdampfungssystemen erfolgen.

Bei der Oxidation der Precursoren wird ein Oxidationsmittel verwendet, das in der Regel ein Gas oder ein Gasgemisch ist. Vorzugsweise wird Sauerstoffgas ($O_2$) verwendet.

Als Substrat kann jedes geeignete Substratmaterial dienen. Dazu zählen Experimentalelektroden, Elektrodenmaterialien zur Integration eines Dielektriums, Edelmetallelektroden, oxidische Elektroden und nicht leitende Substrate.

Die Abscheidung der Metalloxide erfolgt bevorzugt nach dem CVD-Verfahren.

Beim CVD-Verfahren werden chemische Verbindungen, z.B. metallorganische Verbindungen, die sich leicht verdampfen lassen oder bereits Gase sind, auf einer heißen Substratoberfläche zur Reaktion gebracht, um einen Film mit bestimmten Eigenschaften, z.B. einen Metalloxidfilm zu erzeugen.

Je nach ihrer Konsistenz und Stabilität können die Beschleunigermoleküle in den CVD-Reaktor eingeführt werden.

Wenn die Beschleuniger aus gut verdampfenden Molekülen oder aus gasförmigen Molekülen oder Radikalen bestehen, so können sie dem Gasgemisch einfach beigemischt werden. Dies kann an verschiedenen Orten erfolgen, wie es in Fig. 1 als Beispiel dargestellt ist.

Fig. 1 zeigt, daß das Precursorgas aus einer Precursorlösung erzeugt wird, welche in einem Verdampfer in Gas übergeführt wird. Der Verdampfer kann z.B. ein sogenannter Flash-Verdampfer sein. Das Trägergas, z.B. Ar oder $N_2$, transportiert den Dampf zum Showerhead. Dort wird er mit dem Oxidationsgas und evtl. weiterem Trägergas gemischt. Die Verwendung eines Showerheads ist notwendig, um eine gleichförmige, laminare Gasströmung im Reaktor zu gewährleisten. Nach Austritt aus dem Showehead fließt das Gasgemisch aus Precursorgas, Oxidationsgas und Trägergas zum heißem Substrat, wo die entsprechenden Metalloxide abgeschieden werden.

Der leicht zu verdampfende oder gasförmige Beschleuniger kann nun an verschiedenen Orten dem Gasgemisch beigefügt werden: er kann im Oxidationsgas/Trägergasgemisch an Stelle 3 zugefügt werden oder aber dem Precursorgas/Trägergasgemisch an Stelle 4 oder aber separat zusammen mit etwas Trägergas in den Showerhead an Stelle 2 eingeführt werden. Sollte der Beschleuniger sehr reaktiv sein, so kann er auch vollkommen getrennt in den Reaktorraum an Stelle 1 eingeführt werden, z. B. über einen Ring mit Löchern, die zum Substrat gerichtet sind.

Schließlich lassen sich die Beschleuniger auch über das Precursor-Einlaßsystem einbringen. z.B. an Stelle 6 in Fig. 1. Dieses ist beispielsweise mit einem Flash-Verdampfungssystem möglich, das mit einem Liquid Delivery-System (LDS) gekoppelt ist. Im Falle der Verwendung des LDS werden die Moleküle einfach in geringerer Menge vorher der Precursorenlösung beigemischt und dann mit dem Precursoren verdampft. Es ist dabei wichtig, daß die eingesetzten Moleküle noch bei der Temperatur des Precursor-Einlaßsystems stabil sind und nicht mit den Precursoren oder dem Lösungsmittel reagieren.

Je nach CVD-Verfahren läßt sich die Abscheidetemperatur um 50 bis 200°C senken.

Die nachfolgenden Beispiele sollen das erfindungsgemäße Verfahren erläutern.

Beispiel 1

Zur Herstellung eines Dünnfilms aus SBT nach dem CVD-Verfahren werden die metallorganischen Precursoren ($Sr(thd)_2$(tetraglyme)(Bis(2,2,6,6,-tetramethylheptan-3,5-dionato(tetraglyme)strontium), $Ta(thd)(OiPr)_4$ (2,2,6,6-tetramethylheptan-3,5-dionato-tantaltetraisopropoxid und $BiPhe_3$(Triphenylbismuth) in einem Lösungsmittelgemisch aus THF/iPrOH/Tetraglyme (8:2:1) eingesetzt. Diese Lösung wird mit einer Rate von 0,15 ml/min in den Flash-Verdampfer, der sich auf einer Temperatur von 200°C befindet, eingebracht. 200 $cm^3$ Argon dienen als Trägergas. Das so erhaltene Gasgemisch wird in den Showerhead eingebracht. An einem anderen Anschluß des Showerheads werden 600 $cm^3$ Argon und 400 $cm^3$ $O_2$ eingeführt. Diesem Gas werden 10 $cm^3$ $NO_2$ zugemischt. Die Gase werden im Showerhead gemischt und dann in den Reaktorraum entlassen. Dort treffen sie auf einen mit $Pt/Ti/SiO_2$ beschichteten 6"-Si-Wafer. Das Platin hat eine Schichtdicke von 200 nm, das Titan hat eine Schichtdicke von 30 nm und das $SiO_2$ ist 625 nm dick. Die Temperatur des Wafers liegt bei 500°C (oder höher); der Gesamtdruck im Reaktorraum liegt bei 3 Torr. Der Sauerstoffanteil liegt bei 25 bis 80 %.

Es werden spiegelnde SBT-Schichten mit guter Kantenbedeckung erhalten.

Beispiel 2

Zur Abscheidung von BST werden die Precursoren $Sr(thd)_2$(tetraglyme) (Bis(2,2,6,6,-tetramethylheptan-3,5-dionato)(tetraglyme)strontium), $Ba(thd)_2$(tetraglyme) (Bis(2,2,6,6,-tetramethylheptan-3,5-dionato) (tetraglyme)barium)

und Ti(thd)$_2$(OiPr)$_2$ (Bis(2,2,6,6,-tetramethylheptan-3,5-dionato)-titandiisopropoxid) in einem Lbsungsmittelgemisch aus THF/iPrOH/Tetraglyme (8:2:1) eingesetzt. Diese Lösung wird mit einer Rate von 0,15 ml/min in den Flash-Verdampfer, der sich auf einer Temperatur von 240°C befindet, eingebracht. 200 cm$^3$ Argon dienen als Trägergas. Das so erhaltene Gasgemisch wird in den Showerhead eingebracht. An einem anderen Anschluß des Showerheads werden 200 cm$^3$ Argon, 500 cm$^3$ O$_2$ und 500 cm$^3$ N$_2$O eingeführt. Diesem Gas werden 10 cm$^3$ NO$_2$ als Beschleuniger hinzugemischt. Die Gase werden im Showerhead gemischt und dann in den Reaktorraum entlassen. Dort treffen sie auf einen mit Pt/Ti/SiO$_2$ beschichteten 6"-Si-Wafer. Das Platin hat eine Schichtdicke von 200 nm, das Titan hat eine Schichtdicke von 30 nm und das SiO$_2$ ist 625 nm dick. Die Temperatur des Wafers liegt bei 400°C; der Gesamtdruck im Reaktorraum liegt bei 1 Torr.

Es werden spiegelnde BST-Schichten mit guter Kantenbedeckung und guter Abscheiderrate erhalten.

Beispiel 3

Anstelle von 10 ml NO$_2$, wie in Beispiel 1 oder 2, werden 10 ml NO als Beschleuniger eingesetzt. Wieder werden spiegelnde SBT- bzw. BST-Schichten mit guter Kantendeckung und guter Abscheiderate erhalten.

Beispiel 4

Anstelle von 10 ml NO$_2$, wie in Beispiel 1 oder 2 werden 0,02 mMol/min Nitromethan in 50 cm$^3$ Trägergas zusammen mit dem Oxidationsgas/Trägergas eingeführt. Das Nitromethan, das einen Siedepunkt von 101°C (760 Torr) besitzt, wird in einem Bubbler durch Durchleiten des Trägergases verdampft. Der Bubbler ist beheizbar, um einer Abkühlung durch Verdampfung zu begegnen und die Verdampfungsrate einzustellen. Als Alternative kann auch Nitroethan eingesetzt werden (Verdampfungs-temperatur 115°C/760 Torr). Beide Nitroverbindungen zerfallen ab etwa 250°C und setzten dabei Radialketten in Gang.

Auch hier ergeben sich SBT- und BST-Schichten mit ausgezeichneter Kantenabdeckung und guter Abscheiderate.

Beispiel 5

Eine Lösung von Peroxyessigsäure in THF wird in einem Flashverdampfer bei ca. 60°C verdampft. Als Trägergas dienen 100 cm$^3$ Argon. Der Verdampfer speist sein Gas in die Oxidationsgas/Trägergasleistung ein. Daher ist der Druck im Verdampfer derselbe wie im Showerhead und damit nahezu derselbe wie im Reaktionszeitraum. Ansonsten wird wie in Beispiel 1 und 2 verfahren. Es werden ca. 0,02 mMol/min an Peroxyessigsäure verdampft. Anstelle von Peroxyessigsäure kann auch ihr Methyl- oder Ethylester eingesetzt werden.

Beispiel 6

Es wird in der gleichen Weise wie in Beispiel 5 verfahren, mit der Ausnahme, daß Dibenzoylperoxid in THF bei einer Temperatur von ca. 60°C verdampft wird.

Beispiel 7

Es wird in der gleichen Weise wie in Beispiel 5 verfahren, mit der Ausnahme, daß Nitrobenzol in THF bei einer Temperatur von 150°C verdampft wird. Anstatt Nitrobenzol kann auch Nitrosobenzol eingesetzt werden.

Beispiel 8

Die Verfahren von Beispiel 1 bzw. Beispiel 2 werden wiederholt, mit der Ausnahme, daß Nitrobenzol als Beschleuniger verwendet wird. Das Nitrobenzol wird der Precursorenlösung zugegeben und zusammen mit den Precursoren in Precursorenverdampfer verdampft. Alternativ dazu kann auch Nitrosobenzol eingesetzt werden.

Beispiel 9

Die Verfahren von Beispiel 1 bzw. Beispiel 2 werden wiederholt, mit der Ausnahme, daß H$_2$O$_2$ als Beschleuniger verwendet wird. Dazu wird eine 30%ige H$_2$O$_2$-Lösung in Wasser in einem Flash-Verdampfer verdampft. Es wird wieder eine Lieferleistung von 0,02 mMol/min eingehalten. Das Wasser/H$_2$O$_2$-Gasgemisch wird über einen separaten Ring, der sich vor der heißen Substratoberfläche befindet, eingeführt.

Die erhaltenen SBT- bzw. BST-Schichten aus den Beispielen 5 bis 9 zeigen wieder eine gute Kantendeckung eine gute Abscheiderate.

**Patentansprüche**

1. Verfahren zur Herstellung von Dünnfilmen aus oxidischer Keramik durch Abscheiden von Metalloxiden auf eine Oberfläche, das folgende Schritte umfaßt:

   - Verdampfen von metallorganischen Precursoren zur Bildung gasförmiger Precursoren,
   - Zugabe eines Beschleunigers zur Initiierung der Oxidation der Precursoren,
   - Oxidation der Precursoren zur Bildung von Metalloxiden und
   - Abscheiden der Metalloxide auf der Oberfläche.

2. Verfahren nach Anspruch 1,
   **dadurch gekennzeichnet,** daß als Beschleuniger Moleküle, die bereits Radikale sind, zugegeben werden.

3. Verfahren nach Anspruch 2,
   **dadurch gekennzeichnet,** daß als Moleküle jeweils NO, $NO_2$ und $ClO_2$ oder Mischungen daraus verwendet werden.

4. Verfahren nach Anspruch 1,
   **dadurch gekennzeichnet,** daß als Beschleuniger Initiatoren für die radikalische Polymerisation zugegeben werden.

5. Verfahren nach Anspruch 4,
   **dadurch gekennzeichnet,** daß als Initiatioren jeweils Carbonylperoxide, Persäuren und deren Ester, Dialkylperoxide, Diarylperoxide und organische Azoverbindungen verwendet werden.

6. Verfahren nach Anspruch 1,
   **dadurch gekennzeichnet,** daß als Beschleuniger Moleküle, die bei Temperaturen oberhalb von 300°C in Radikale zerfallen, zugegeben werden.

7. Verfahren nach Anspruch 6,
   **dadurch gekennzeichnet,** daß als Moleküle jeweils Nitroalkane, Nitroaromaten, Nitrosoalkane und Nitrosoaromraten verwendet werden.

8. Verfahren nach Anspruch 1,
   **dadurch gekennzeichnet,** daß als Beschleuniger Radikale zugegeben werden, die durch physikalische Aktivierung erzeugt werden.

9. Verfahren nach Anspruch 8,
   **dadurch gekennzeichnet,** daß die Radikale Sauerstoffradikale sind, die durch UV-Licht-Bestrahlung von Sauerstoff, $N_2O$, NO oder $NO_2$ erzeugt werden.

10. Verfahren nach mindestens einem der vorangegangenen Ansprüche,
    **dadurch gekennzeichnet,** daß der Beschleuniger im molaren Verhältnis von Beschleuniger zu Precursor im Bereich von 1:1 bis 1:1000 eingesetzt wird.

11. Verfahren nach Anspruch 1,
    **dadurch gekennzeichnet,** daß als Beschleuniger reaktive Spezies zugegeben werden.

12. Verfahren nach Anspruch 11,
    **dadurch gekennzeichnet,** daß als reaktive Spezies Carbokationen von organischen Estern oder Carbene von Diazoverbindungen verwendet werden.

13. Verfahren nach Anspruch 11,
    **dadurch gekennzeichnet,** daß die reaktive Spezies im molearen Verhältnis von Beschleuniger zu Precursor im Bereich von 1:5 bis 1:0,1 eingesetzt wird.

14. Verfahren nach mindestens einem der vorangegangenen Ansprüche,
    **dadurch gekennzeichnet,** daß als metallorganische Percursoren jeweils $BiPh_3$, $Bi(thd)_3$, Bi-pivalat, Trispentoxyla-

tobismuth, Bi-tris(dimethylamid), $Ta(OEt)_5$, $Ta(thd)(OiPr)_4$, $Sr(thd)_2$, $Ba(thd)_2$, $Ti(thd)_2(OiPr)_2$, $Ti(OiPr)_4$, $Zr(thd)_4$ und $Pb(thd)_2$ oder deren Mischungen verwendet werden.

15. Verfahren nach mindestens einem der vorangegangenen Ansprüche,
**dadurch gekennzeichnet,** daß bei der Oxidation der Percursoren ein Oxidationsmittel verwendet wird.

16. Verfahren nach Anspruch 15,
**dadurch gekennzeichnet,** daß als Oxidationsmittel ein Gas oder ein Gasgemisch verwendet wird.

17. Verfahren nach Anspruch 16,
**dadurch gekennzeichnet,** daß ein Sauerstoffgas verwendet wird.

18. Verfahren nach mindestens einem der vorangegangenen Ansprüche,
**dadurch gekennzeichnet,** daß die Metalloxide nach dem CVD-Verfahren abgeschieden werden.

19. Verfahren nach Anspruch 18,
**dadurch gekennzeichnet,** daß der Beschleuniger mit dem Gasgemisch aus Trägergas und Reaktionsgas in den Reaktor eingeführt wird.

20. Verfahren nach Anspruch 18,
**dadurch gekennzeichnet,** daß der Beschleuniger über einen separaten Gaseinlaß eingeführt wird.

21. Verfahren nach Anspruch 18,
**dadurch gekennzeichnet,** daß der Beschleuniger über das Precursoreinlaßsystem eingeführt wird.

Fig.1

kinetisch kontrolliert          Transport kontrolliert

**Fig.2**

obere Pt-Elektrode
Dielektrikum
untere Pt-Elektrode

← Plug

**Fig. 3**

**Europäisches Patentamt**

# EUROPÄISCHER RECHERCHENBERICHT

Nummer der Anmeldung

EP 98 10 7568

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | PATENT ABSTRACTS OF JAPAN vol. 018, no. 495 (C-1250), 16. September 1994 & JP 06 166597 A (MITSUBISHI MATERIALS CORP), 14. Juni 1994 | 1,14-18, 20 | C23C16/40 |
| A | * Zusammenfassung * | 10 | |
| X | WO 93 13243 A (ATOCHEM NORTH AMERICA ELF) 8. Juli 1993 * Seite 5, Zeile 1 - Seite 6, Zeile 28 * | 1,18 | |
| A | TAKUMA KATAYAMA ET AL: "PHOTO-MOCVD OF PBTIO3 THIN FILMS" JOURNAL OF CRYSTAL GROWTH, Bd. 115, Nr. 1 / 04, 2. Dezember 1991, Seiten 289-293, XP000322706 * Absatz 2 * | 2,3,8,9 | |
| A | EP 0 560 617 A (KAWASAKI STEEL CO) 15. September 1993 * Seite 12, Zeile 1 - Zeile 14 * | 6,7 | |
| A | US 5 637 351 A (O'NEAL HARRY E ET AL) 10. Juni 1997 * Zusammenfassung * | 4,5 | **RECHERCHIERTE SACHGEBIETE (Int.Cl.6)**<br><br>C23C |
| P,X | US 5 686 151 A (OKANO HARUO ET AL) 11. November 1997 * Beispiel 1 * -& JP 07 273216 A (TOSHIBA CORP) 20. Oktober 1995 -& JP 07 086270 A (TOSHIBA CORP) 31. März 1995 | 1,2, 14-18,20 | |

Der vorliegende Recherchenbericht wurde für alle Patentansprüche erstellt

| Recherchenort | Abschlußdatum der Recherche | Prüfer |
|---|---|---|
| DEN HAAG | 5. November 1998 | Ekhult, H |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

......................................................................
& : Mitglied der gleichen Patentfamilie, übereinstimmendes Dokument